# FASCICULE DE BREVET EUROPEEN

(11) **EP 1 921 520 B1**
(45) Date de publication et mention de la délivrance du brevet: **28.01.2009**
(21) Numéro de dépôt: 06123973.7
(22) Date de dépôt: 13.11.2006
(51) Int. Cl.: G04C 3/00, G04C 3/12, G04C 3/14, H02N 1/00

(54) **Module d'entraînement comportant un micromoteur MEMS, procédé de fabrication de ce module, et pièce d'horlogerie équipée de ce module**
Einen MEMS-Mikromotor umfassendes Antriebsmodul, Verfahren zur Herstellung dieses Moduls und mit diesem Modul ausgerüstete Uhr
Drive module incorporating an MEMS micromotor, manufacturing process for this module, and time piece equipped with this module

(43) Date de publication de la demande: 14.05.2008
(73) Titulaire: ETA SA Manufacture Horlogère Suisse, 2540 Grenchen (CH)
(72) Inventeur: Paratte, Lionel, 2000, Neuchâtel (CH); Zanetta, André, 2000, Neuchâtel (CH); Meister, Pierre-André, 2502, Biel (CH); Pétremand, Yves, 1400, Yverdon-les-Bains (CH); Golay, Nicolas, 2000, Neuchâtel (CH); Blondeau, Fabien, 2525, Le Landeron (CH); Noell, Wilfried, 2000, Neuchâtel (CH)
(74) Mandataire: Ravenel, Thierry Gérard Louis

(56) Documents cités:
- FR-A1- 2 101 203
- FR-A1- 2 874 907
- US-A1- 5 959 376
- US-B1- 6 211 599

## Description

La présente invention concerne un module d'entraînement pour un rouage d'horlogerie et une pièce d'horlogerie telle qu'une montre-bracelet équipée d'un tel module d'entraînement.

L'invention concerne plus particulièrement un module d'entraînement destiné à engrener avec une roue horlogère, comportant une plaque en matériau cristallin ou amorphe comprenant une couche inférieure qui constitue un substrat, et une couche supérieure dans laquelle est gravée un micromoteur du type MEMS, dans lequel le micromoteur comporte au moins un actionneur entraînant en rotation un rotor.

Les puces en silicium sont usuellement de forme rectangulaire pour maximiser le nombre de pièces par wafer. Ceci convient bien à l'arrangement de blocs fonctionnels au niveau électronique, car eux-mêmes sont rectangulaires également. Dans le cas d'un micromoteur du type MEMS réalisé dans une plaque en silicium et utilisant des actionneurs électrostatiques à peignes interdigités ou "comb drive", le ou les actionneur(s) ont bien en général une forme rectangulaire mais, comme ils doivent générer de grandes forces, ils occupent de grandes surfaces et ils ne peuvent donc pas être segmentés en plusieurs blocs pour être répartis de façon optimale sur une puce rectangulaire. Le rotor du micromoteur étant circulaire, l'optimisation de la surface occupée sur la plaque de silicium portant le micromoteur et sur le wafer est rendue encore plus difficile, ce qui conduit à de grandes surfaces de silicium inutilisées. Cette optimisation peut être rendue encore plus complexe lorsque l'on souhaite maximiser le rendement du micromoteur en optimisant la disposition du ou des actionneur(s).

Le document FR 2 874 907 décrit un module d'entraînement composé de deux micromoteurs actionnant une même dent d'entraînement respectivement tangentiellement et radialement afin de créer un mouvement hybride résultant de ces deux directions apte à déplacer un rouage horloger.

Le document US 6.211,599 décrit un module d'entraînement composé de plusieurs micromoteurs actionnant chacun une dent ou un crochet tangentiellement afin de créer un mouvement continu à partir de chaque actionneur alternativement.

L'invention vise à résoudre ces problèmes en proposant un module d'entraînement qui permette une optimisation de tous ces paramètres, notamment en optimisant la surface de silicium nécessaire à la fabrication du module, tout en obtenant un micromoteur à rendement élevé.

Dans ce but, l'invention propose un module d'entraînement du type mentionné précédemment, caractérisé en ce qu'un pignon, coaxial au rotor, est lié en rotation au rotor et est agencé au-dessus du rotor, le pignon étant prévu pour engrener avec la roue horlogère dans une zone d'engrènement située à proximité d'un bord périphérique extérieur de la plaque, en ce que le rotor est agencé sur la plaque de manière à minimiser la distance entre le bord périphérique extérieur du rotor et le bord périphérique extérieur de la plaque correspondant à la zone d'engrènement, et en ce que le diamètre du pignon est supérieur à celui du rotor de manière à être en porte-à-faux par rapport à la plaque dans la zone d'engrènement.

Selon d'autres caractéristiques de l'invention :
- l'actionneur comporte un stylet mobile suivant une direction parallèle au plan de la plaque, le stylet étant muni à son extrémité libre d'un cliquet prévu pour coopérer avec une denture à dents de scie aménagée sur le bord périphérique extérieur du rotor en vue de l'entraîner en rotation séquentiellement, et la position angulaire de la zone d'encliquetage du cliquet avec le rotor est légèrement décalée angulairement par rapport à la zone d'engrènement ;
- le stylet s'étend suivant une direction qui coupe l'actionneur en deux parties globalement symétriques ;
- il est prévu deux actionneurs qui comportent chacun un stylet mobile dont l'extrémité libre est pourvue d'un cliquet, l'un de poussée, l'autre de traction, coopérant avec la denture du rotor de part et d'autre de la zone d'engrènement ;
- les actionneurs décrivent entre eux un angle compris globalement entre quatre-vingt degrés et cent quarante degrés, la bissectrice de cet angle passant par la zone d'engrènement et par l'axe de rotation du rotor, de sorte que la plaque a une forme générale en "V" définie par le contour extérieur de la plaque;
- la plaque comporte une portion centrale qui porte le rotor et deux portions latérales, le contour de la plaque correspond globalement à l'intersection de deux rectangles, qui sont orthogonaux entre eux et qui forment les deux portions latérales, avec un rectangle transversal, qui forme la portion centrale, le rectangle transversal décrivant un angle de quarante-cinq degrés par rapport à chacun des deux autres rectangles, la majeure partie de la surface de chaque portion latérale est occupée par un actionneur alors que la majeure partie de la surface de la portion centrale est occupée par le rotor, et la zone d'engrènement est agencée à proximité d'un des bords périphériques de la portion centrale ;
- la plaque comporte des plages de connexion pour le raccordement des actionneurs à un module électronique, et les plages sont agencées sur la portion centrale, du côté opposé à la zone d'engrènement par rapport à l'axe du rotor ;
- le module d'entraînement est agencé à l'intérieur d'un boîtier comportant une platine inférieure prévue pour être fixée sur un élément de pièce d'horlogerie tel qu'une platine de mouvement et un capot fixé sur la platine inférieure ;
- le capot comporte une échancrure ouverte dans un de ses bords périphériques extérieurs et le pignon est logé dans l'échancrure.

L'invention propose aussi un procédé de fabrication du module d'entraînement caractérisé en ce qu'il comporte une étape de gravage de plusieurs plaques dans une plaquette de matériau cristallin ou amorphe tel qu'un wafer en silicium, les plaques étant imbriquées selon plusieurs colonnes à la manière de chevrons, les plaques de deux colonnes contiguës étant orientées en sens opposés.

L'invention propose encore une pièce d'horlogerie comportant un rouage entraîné en rotation par le module d'entraînement selon l'une des caractéristiques précédentes.

D'autres caractéristiques et avantages de la présente invention apparaîtront plus clairement à la lecture de la description détaillée qui suit, faite en référence aux dessins annexés donnés à titre d'exemple non limitatifs et dans lesquels :
- la figure 1 est une vue en coupe qui représente schématiquement une pièce d'horlogerie réalisée conformément aux enseignements de l'invention;
- la figure 2 est une vue en perspective qui représente partiellement le mouvement de la pièce d'horlogerie de la figure 1 équipé d'un module d'entraînement comportant un micromoteur MEMS;
- la figure 3 est une vue de dessus qui représente schématiquement le module d'entraînement de la figure 2;
- la figure 4 est une vue en perspective éclatée qui représente le module d'entraînement de la figure 2 et le boîtier enveloppant ce module d'entraînement;
- la figure 5 est une vue agrandie en coupe axiale suivant le plan 5-5 qui représente schématiquement une portion du module d'entraînement et qui illustre le montage à rotation d'un pignon et d'un rotor du micromoteur autour d'un arbre;
- la figure 6 est une vue en coupe axiale schématique suivant le plan X'X qui illustre l'entraînement du pignon par le rotor au moyen de goupilles;
- la figure 7 est une vue de dessus schématique qui illustre l'entraînement du pignon par le rotor au moyen de goupilles;
- la figure 8 est une vue en coupe axiale schématique suivant le plan X'X qui illustre une variante du montage de l'arbre par rapport au rotor;
- la figure 9 est une vue de dessous qui représente schématiquement les structures élastiques de fixation qui sont aménagées dans la plaque pour le serrage et le centrage de l'arbre selon le montage de la figure 8;
- la figure 10 est une vue de dessus qui représente schématiquement un wafer en silicium et qui illustre un exemple d'agencement de plusieurs micromoteurs sur le wafer.

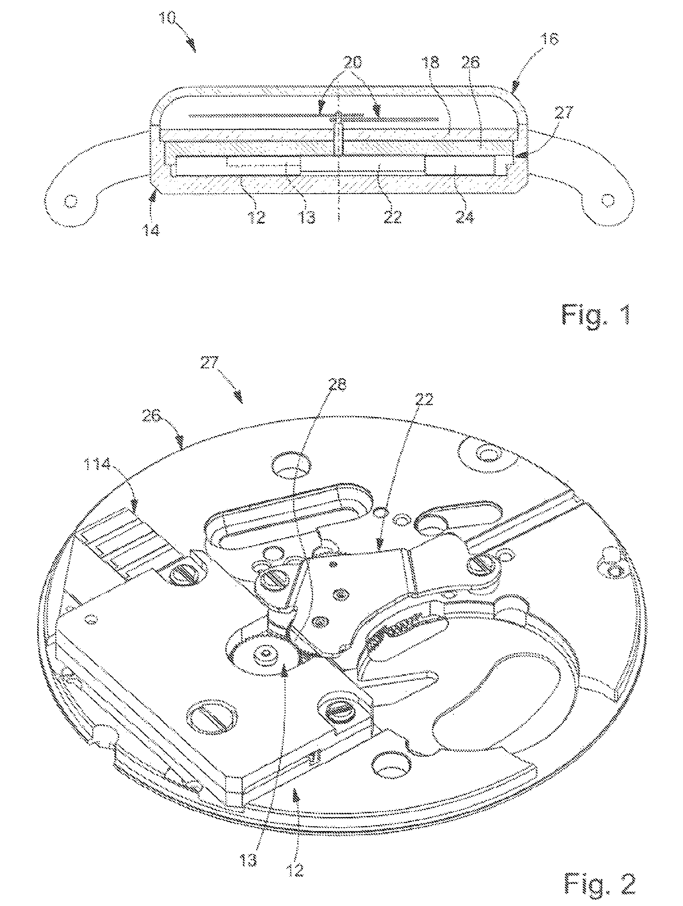

Sur la figure 1, on a représenté schématiquement une pièce d'horlogerie 10 constituée par une montre-bracelet équipée d'un module d'entraînement 13 conforme aux enseignements de l'invention, le module d'entraînement 13 étant ici agencé à l'intérieur d'un boîtier 12.

La pièce d'horlogerie 10 comporte une boîte de montre 14 fermée par une glace 16, un cadran 18, et des moyens d'affichage analogique constituées ici par des aiguilles 20. Les aiguilles 20 sont prévues pour être entraînées en rotation par le module d'entraînement 13 selon l'invention, via un rouage 22 comportant, par exemple, des moyens de démultiplication. Le module d'entraînement 13 est alimenté en énergie électrique par une pile 24. Le boîtier 12, le module d'entraînement 13, le rouage 22, et la pile 24 sont ici montés sur une platine 26 et forment ensemble le mouvement 27 de la pièce d'horlogerie 10, ce mouvement 27 étant fixé à l'intérieur de la boîte de montre 14. Bien entendu, le mouvement 27 comporte d'autres éléments (non représentés), en particulier un module électronique comportant un circuit intégré, une base de temps comportant un quartz, une plaque à circuits imprimés etc.

Sur la figure 2, on a représenté une partie du mouvement 27 de la pièce d'horlogerie 10, en particulier la platine 26 sur laquelle sont montés le boîtier 12 et le rouage 22.

Le module d'entraînement 13 est destiné à engrener avec une roue horlogère dite roue d'entrée 28 du rouage 22.

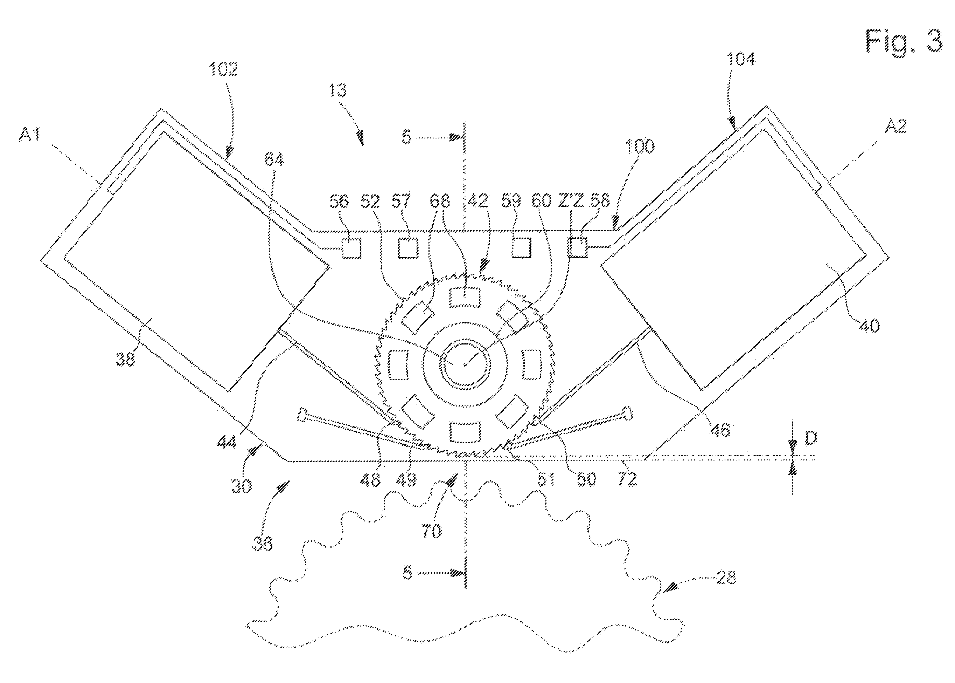

Les différents éléments du module d'entraînement 13 selon l'invention sont représentés plus en détail sur les figures 3 à 7.

Le module d'entraînement 13 comporte une plaque 30 en matériau cristallin ou amorphe, par exemple du silicium, comprenant une couche inférieure qui constitue un substrat 32, et une couche supérieure 34 dans laquelle est gravée un micromoteur 36 du type MEMS (Micro ElectroMechanical System). Le micromoteur 36 est constitué ici par deux actionneurs 38, 40 entraînant en rotation un rotor 42 gravé dans la couche supérieure 34.

Chaque actionneur 38, 40 comporte un stylet 44, 46 mobile suivant une direction A1, A2 parallèle au plan de la plaque 30. Chaque stylet 44, 46 est muni à son extrémité libre d'un cliquet 48, 50 prévu pour coopérer avec une denture 52 à dents de scie aménagée sur le bord périphérique extérieur du rotor 42 en vue de l'entraîner en rotation séquentiellement.

De préférence, chaque stylet 44, 46 s'étend suivant une direction A1, A2 qui coupe l'actionneur 38, 40 associé en deux parties globalement symétriques. De préférence, un premier actionneur 38 comporte un cliquet de poussée 48 et un second actionneur 40 comporte un cliquet de traction 50.

Chaque actionneur 38, 40 est ici du type électrostatique à peignes interdigités et réalisé par gravure dans la plaque 30 en silicium. La plaque 30 est ici du type Silicon On Insulator (SOI) et comprend une couche inférieure 32 épaisse de substrat en silicium, une couche intermédiaire 54 d'oxyde de silicium , et une couche supérieure 34 en silicium d'épaisseur inférieure au substrat 32.

La partie fixe de chaque actionneur 38, 40 comporte une plage 56, 58 d'alimentation prévue pour être raccordée électriquement au module électronique, et la partie mobile de chaque actionneur 38, 40 comporte une plage de contact 57, 59 qui place ces parties mobiles à un potentiel déterminé, ici à zéro Volts.

Un micromoteur comportant des actionneurs électrostatiques réalisés dans une plaque en silicium est décrit et représenté, par exemple, dans le document WO 2004/081695, incorporé ici par référence. Dans ce document, le moteur est réalisé par gravure dans une couche de silicium. Il comporte une roue d'entraînement dentée et des doigts d'actionnement qui coopèrent avec les dents de la roue pour provoquer sa rotation. Chaque doigt d'actionnement est solidaire en déplacement d'un peigne mobile qui se déplace par rapport à un peigne fixe en fonction d'une tension appliquée sur le peigne fixe.

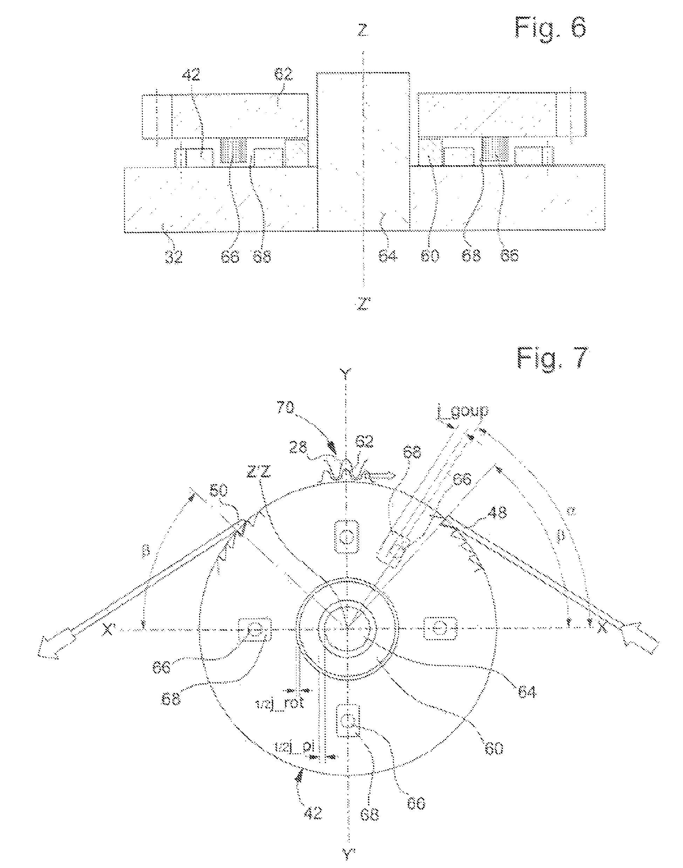

Un mode de réalisation utilisant une plaque SOI est décrit en référence aux figures 7A à 7D dans le document mentionné ci-dessus.

Selon un mode de réalisation avantageux, chaque actionneur 38, 40 est associé à un cliquet passif 49, 51 dont la zone d'encliquetage est située entre la zone d'engrènement 70 et la zone d'encliquetage du cliquet associé. Ces cliquets passifs 49, 51 sont maintenus élastiquement engrenés avec le rotor 42 de manière à assurer un positionnement angulaire précis, notamment au cours des phases d'entraînement, lorsque les autres cliquets 48, 50 se déplacent.

Selon le mode de réalisation représenté sur les figures 3 à 7, le rotor 42 est guidé par un palier 60 lisse central intégré ou cheminée, réalisé en même temps que les cliquets 48, 50, et ayant un jeu diamétral situé entre 4 et 10 microns, limite inférieure approximative correspondant à une couche de silicium épaisse de 80 microns. Les cliquets 48, 50 fonctionneront bien s'ils agissent sur une course tangentielle significativement supérieure à ce jeu, soit typiquement entre 20 et 100 microns. Ceci correspond bien à la gamme de courses possibles avec un guidage des stylets 44, 46 par ressorts de flexion (non représentés).

Le couple du rotor 42 est transmis à un pignon 62 par un système apparenté à une manivelle. Le pignon 62 situé juste au-dessus du rotor 42, est coaxial à ce dernier et il est guidé par un arbre 64 central. Le pignon 62 est doté de goupilles 66, engagées dans des fenêtres 68 du rotor 42. Des jeux de fonctionnement j_goup, j_rot, j_pi sont ménagés entre les divers éléments du rotor 42 et du pignon 62 comme représentés sur le schéma de la figure 7. Ainsi rotor 42 et pignon 62 sont couplés angulairement, mais indépendants latéralement : les jeux dans le plan xy sont repris par le palier 60 pour le rotor 42 et par l'arbre 64 pour le pignon 62. Ainsi la force de réaction latérale due à la charge n'est pas reprise par le palier 60 au niveau du rotor 42, mais par le guidage du pignon 62 par l'arbre 64. Ainsi les éléments microfabriqués du micromoteur 36 sont protégés des forces plus grandes exercées par les éléments horlogers, en cas de chocs par exemple.

Le pignon 62 est prévu pour engrener avec la roue d'entrée 28 du rouage 22 dans une zone d'engrènement 70 située à proximité d'un bord périphérique extérieur 72 de la plaque 30.

Selon une caractéristique avantageuse, le rotor 42 est agencé sur la plaque 30 de manière à minimiser la distance D entre la denture 52 du rotor 42 et le bord périphérique extérieur 72 de la plaque 30 correspondant à la zone d'engrènement 70. De plus, le diamètre extérieur du pignon 62 est légèrement supérieur à celui du rotor 42 de manière à être en porte-à-faux par rapport à la plaque 30 dans la zone d'engrènement 70.

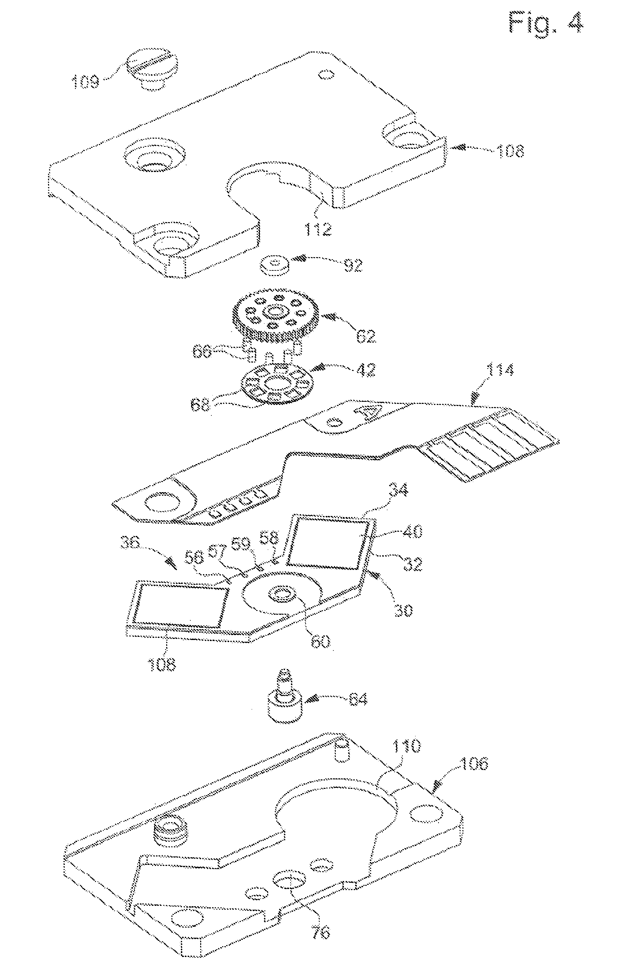

Pour simplifier le schéma de la figure 7, on a représenté un rotor 42 comportant seulement quatre fenêtres 68 et un pignon 62 comportant seulement quatre goupilles 66. Selon un mode de réalisation avantageux, tel qu'illustré notamment par les figures 3 et 4, il est prévu huit fenêtres 68 et huit goupilles 66.

Selon un mode de réalisation préféré, la position angulaire de la zone d'encliquetage de chaque cliquet 48, 50 avec le rotor 42 est décalée angulairement par rapport à la zone d'engrènement 70. La zone d'encliquetage de chaque cliquet 48, 50 forme un angle β avec l'axe x'x. α représente l'angle, à un instant donné, entre le rayon passant par la goupille 66 qui est en appui, en prise, contre le bord de sa fenêtre 68, et l'axe x'x (figure 7).

Ensuite, un choix judicieux de l'ensemble des paramètres {α, β, j_rot, j_pi, j_goup} pour des rayons de pignon 62, de rotor 42 et du cercle de goupilles 66 donnés favorisera le rendement de la transmission de l'énergie mécanique depuis le rotor 42 vers le pignon 62. Ainsi, pour un cas particulier de l'invention ayant β = 45°, si les jeux sont bien ajustés, le rendement pour un système à quatre goupilles avoisine les 85%, ce qui améliore le rendement par rapport à un cas où le rotor 42 et le pignon 62 sont collés l'un à l'autre. En effet, dans ce dernier cas toute la charge se retrouverait sous forme de frottement silicium-silicium latéral au niveau du palier 60, et vertical entre la périphérie du rotor 42 et le substrat 32 à cause du couple de basculement. Or le frottement silicium-silicium est plutôt défavorable, avec des coefficients secs statiques approchant 0,4.

Cette solution de transmission permet encore de varier le diamètre du pignon 62 afin d'adapter les couples et les vitesses, selon les charges. De plus, si le pignon 62 est assez grand et dépasse du bord périphérique 72 de la plaque 30, l'engrènement par la tranche s'en trouve simplifié, et le module d'entraînement 13 peut être assemblé sur la platine 26 de la pièce d'horlogerie 10 de façon modulaire, c'est-à-dire sans démonter/remonter la roue 28 entraînée.

Selon différentes variantes :
- le rotor 42 est microfabriqué en place, et sur le même substrat 32 que les actionneurs 38, 40, afin de garantir un appairage au palier 60 et aux cliquets;
- une autre variante consiste à fabriquer un rotor 42 séparément, sur le même wafer ou sur un autre wafer, ce rotor 42 étant ensuite assemblé sur la plaque 30 ou stator. Ceci permet une réduction du jeu radial si désiré dans le cas où le rotor est guidé par le palier 60;
- une famille de variantes est constituée par des rotors 42 et/ou des pignons 62 microfabriqués par d'autres procédés que l'usinage DRIE (découpe laser, EDM, LIGA, microinjection, etc.) puis assemblés sur la plaque 30 au stator;
- une autre famille de variantes est constituée de goupilles 66 formées par un deuxième niveau photolithographique dans le pignon 62 et/ou dans le rotor 42.

Le module d'entraînement 13 selon l'invention permet une modularité accrue pour l'adaptation à la charge, en permettant l'utilisation de pignons 62 de divers diamètres, sans modifier le reste du module 13. On obtient aussi une modularité accrue pour l'assemblage car l'interface mécanique pour la liaison au rouage 22 horloger est déjà existante grâce à la présence du pignon 62, intégré au module d'entraînement 13 et lié en rotation au micromoteur 36.

Le pignon 62 peut être réalisé en métal tel que du laiton, avec des goupilles 66 rapportées réalisées aussi en métal. Le pignon 62 peut aussi être réalisé d'une seule pièce avec les goupilles 66 par moulage en matériau plastique. Une réalisation du pignon 62 en matériau plastique avec des goupilles 66 métalliques surmoulées est aussi envisageable.

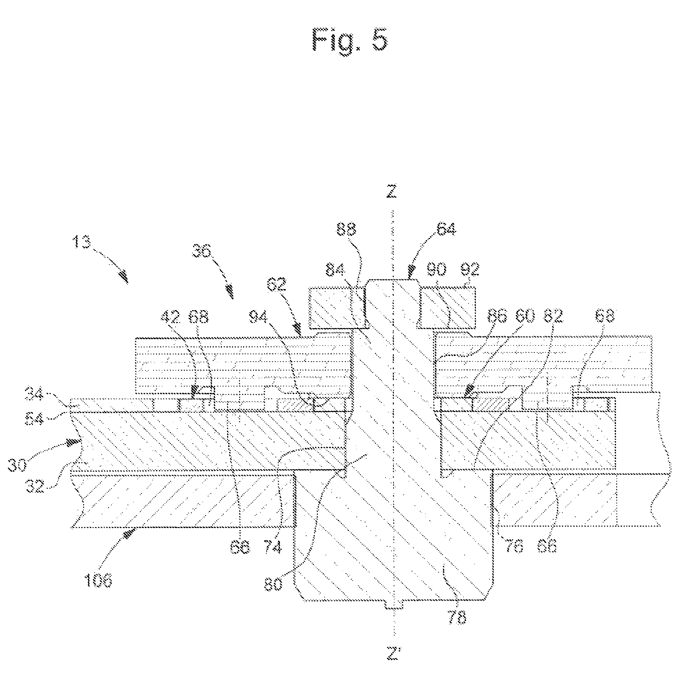

Selon le mode de réalisation représenté notamment sur les figures 4 et 5, l'axe de rotation du pignon 62 est constitué par un arbre 64 étagé en métal décolleté qui est inséré dans la plaque 30 à travers un premier trou 74 réalisé dans le substrat 32 et qui est chassé dans un second trou 76 réalisé dans une platine 106 du boîtier 12. Dans ce mode de réalisation, les efforts radiaux appliqués sur l'arbre 64 sont repris par la platine 106.

L'arbre 64 comporte un tronçon d'extrémité inférieure 78 qui délimite avec un tronçon intermédiaire inférieur 80 une première surface d'épaulement 82 orientée vers le haut et venant en butée axiale contre la face inférieure de la plaque 30. Le tronçon intermédiaire inférieur 80 a un diamètre sensiblement égal au diamètre du premier trou 74 et il s'étend dans ce trou 74. L'arbre comporte un tronçon intermédiaire supérieur 84 de diamètre légèrement inférieur au tronçon intermédiaire inférieur 80 adjacent et qui s'étend dans l'alésage 86 du pignon 62 pour le guider en rotation. Le tronçon intermédiaire supérieur 84 délimite avec le tronçon d'extrémité supérieure 88 une seconde surface d'épaulement 90 contre laquelle est maintenue en appui axial une bague de fixation 92 qui est chassée sur le tronçon d'extrémité supérieure 88.

Comme le guidage en rotation du rotor 42 est réalisé par le palier 60, qui est réalisé par un procédé photolithographique de gravure de la même manière que premier trou 74 qui détermine le centrage de l'arbre 64 par rapport au palier 60, on obtient un très bon centrage de l'arbre 64, du pignon 62, du palier 60 et du rotor 42.

De plus, la face inférieure du pignon 62 comporte, en vis-à-vis du palier 60, un bossage 94 qui empêche le pignon 62 de venir en appui axial contre le rotor 42, notamment en cas de basculement, ce qui évite une détérioration du rotor 42.

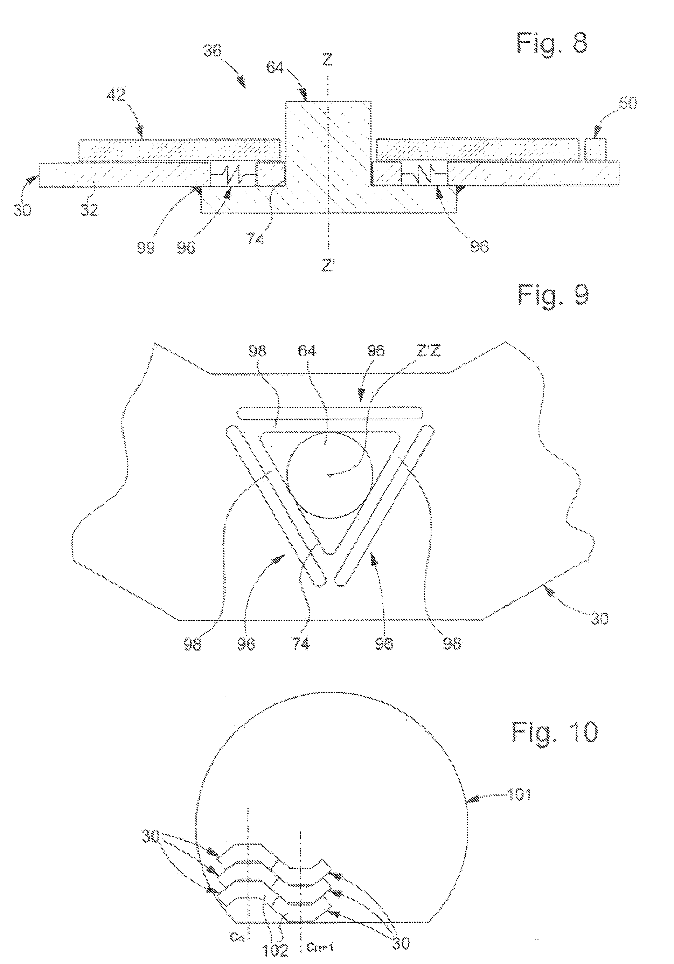

Sur les figures 8 et 9, on a représenté un autre mode de réalisation avantageux dans lequel l'arbre 64 est monté dans la plaque 30 à la manière d'un chassage au moyen de structures élastiques de fixation 96 aménagée dans le substrat 32 autour du premier trou 74. Dans ce mode de réalisation, les efforts radiaux appliqués sur l'arbre 64 sont repris par le substrat 32 et donc par les structures élastiques de fixation 96.

Les structures élastiques de fixation 96 sont constituées ici par des lames flexibles 98 lithographiées dans la face arrière de la plaque 30. La lithographie de la face avant, pour la couche supérieure 34 comportant les cliquets 48, 50 et le rotor 42, étant également alignée et centrée très précisément par rapport à la lithographie de la face arrière (erreur inférieure à 1 micron), il en résulte un guidage et un centrage plus précis qu'avec un axe réalisé d'une seul pièce avec la plaque 30, puisque le jeu radial peut être également réduit à un micron.

Grâce à cet alignement et ce centrage précis, il est possible de supprimer le palier 60 de sorte que le rotor 42 est alors guidé en rotation directement par l'arbre 64. Ainsi l'arbre 64 peut guider en rotation à la fois le rotor 42 et le pignon 62. Comme l'arbre 64 est réalisé par décolletage, ce qui permet d'obtenir des tolérances de fabrication très restreintes, on obtient un assemblage très précis, ce qui assure notamment un fonctionnement fiable des actionneurs 38, 40. Le rotor 42 est alors guidé par la paroi axiale externe de l'arbre 64.

L'arbre 64 peut être finalement fixé dans la plaque 30 par un moyen de fixation complémentaire, par exemple par soudage au substrat 32 au moyen d'un cordon de soudure 99 qui est représenté sur la figure 8, ou encore par collage.

Les problèmes de frottement contre l'arbre 64 peuvent être résolus par déposition d'une couche mince solide sur la paroi axiale externe de l'arbre 64 permettant de diminuer le frottement entre les pièces.

Les structures élastiques de fixation 96 peuvent être choisies notamment parmi les exemples décrits et représentés dans le document CH 695 395 ou parmi d'autres structures qui peuvent assurer un centrage précis et un serrage de l'arbre 64 sur la plaque 30, par exemple des structures constituées de languettes flexibles à extrémités libres.

Avantageusement, en considérant notamment la figure 3, les actionneurs 38, 40 décrivent entre eux un angle d'environ quatre-vingt-dix degrés, la bissectrice de cet angle passant par la zone d'engrènement 70 et par l'axe de rotation z'z du rotor 42, de sorte que le module d'entraînement 13 a une forme générale en "V" définie par le contour extérieur de la plaque 30, ce contour étant optimisé.

La plaque 30 comporte une portion centrale 100 qui porte le rotor 42 et deux portions latérales 102, 104. Le contour extérieur de la plaque 30 correspond globalement à l'intersection de deux rectangles, qui sont orthogonaux entre eux et qui forment les deux portions latérales 102, 104, avec un rectangle transversal, qui forme la portion centrale 100, le rectangle transversal décrivant un angle de quarante-cinq degrés par rapport à chacun des deux autres rectangles. La majeure partie de la surface de chaque portion latérale 102, 104 est occupée par un actionneur 38, 40 alors que la majeure partie de la surface de la portion centrale 100 est occupée par le rotor 42. La zone d'engrènement 70 est agencée à proximité d'un des bords périphériques 72 de la portion centrale 100.

De préférence, les plages 56, 57, 58, 59 sont agencées sur la portion centrale 100, du côté opposé à la zone d'engrènement 70 par rapport à l'axe z'z du rotor 42.

On note que la forme en "V" du module d'entraînement 13 présente l'avantage de permettre une optimisation du rendement du micromoteur 36 par rapport à la surface de la plaque 30 utilisée, et une optimisation de la surface de matériau cristallin ou amorphe utilisée pour réaliser les micromoteurs 36 et les modules d'entraînement 13. Ainsi, lorsque la plaque 30 est réalisée à partir d'un wafer 101 en silicium, comme schématisé sur la figure 10, la forme en "V" permet une réplication imbriquée des plaques 30 sur la surface du wafer pour maximiser le nombre de micromoteurs 36 obtenus à partir d'une surface donnée de silicium. En particulier, selon l'exemple représenté sur la figure 10, les plaques 30 peuvent être rangées sur le wafer en colonnes parallèles à la manière de chevrons, deux colonnes Cn, Cn+1 adjacentes étant orientées dans des sens opposés. De plus, deux plaques 30 adjacentes de deux colonnes Cn, Cn+1 adjacentes ont leurs portions latérales 102 adjacentes qui sont alignées.

De préférence, l'angle décrit par les deux actionneurs 38, 40 est compris entre quatre-vingt-dix et cent quarante degrés. Plus l'angle est important, plus l'imbrication des plaques 30 sur le wafer 101 est optimisée, mais les angles importants nécessitent de déporter les stylets 44, 46 des actionneurs 38, 40 par rapport à leurs axes de symétrie A1, A2 respectifs, ce qui pénalise l'efficacité mécanique des actionneurs 38, 40.

Selon le mode de réalisation représenté sur les figures, le boîtier 12 qui contient le module d'entraînement 13 comporte une platine inférieure 106 prévue pour être fixée sur un élément de la pièce d'horlogerie 10, ici sur la platine 26 du mouvement, et la plaque 30 du module d'entraînement 13 est montée sur la platine inférieure 106. Le boîtier 12 comporte un capot 108 de protection qui recouvre le module d'entraînement 13, qui est fixé sur la platine inférieure 106, ici au moyen d'une vis 109, et qui retient le module d'entraînement 13 contre la platine inférieure 106.

La face supérieure de la platine inférieure 106 comporte ici une creusure ou logement 110 dans lequel la plaque 30 du module d'entraînement 13 est reçue de manière sensiblement complémentaire.

Le capot 108 comporte une échancrure 112 ouverte dans un de ses bords périphériques extérieurs et le pignon 62 est logé dans cette échancrure 112 après montage du capot 108 sur la platine inférieure 106.

Avantageusement, un circuit imprimé 114 est intercalé entre la platine inférieure 106 et le capot 108 pour permettre le raccordement électrique du micromoteur 36, par ses plages 56, 57, 58, 59, au module électronique de la pièce d'horlogerie 10.

Selon une variante de réalisation (non représentée), le module d'entraînement 13 peut être monté directement sur la platine 26, ce qui permet de supprimer le boîtier 12, notamment pour minimiser le nombre de composants, pour faciliter l'assemblage du mouvement 27, et pour minimiser l'encombrement des moyens d'entraînement. Un élément de protection peut être prévu sur le module d'entraînement 13 pour protéger ses composants.

## Revendications

1. Module d'entraînement (13) destiné à engrener avec une roue (28) horlogère, comportant une plaque (30) en matériau cristallin ou amorphe comprenant une couche inférieure qui constitue un substrat (32), et une couche supérieure (34) dans laquelle est gravée un micromoteur (36) du type MEMS, dans lequel le micromoteur (36) comporte au moins un actionneur (38, 40) entraînant en rotation un rotor (42), un pignon (62), coaxial au rotor, étant lié en rotation audit rotor et étant agencé au-dessus dudit rotor, **caractérisé en ce que** le pignon est prévu pour engrener avec la roue horlogère dans une zone d'engrènement (70) située à proximité d'un bord périphérique extérieur (72) de la plaque (30), **en ce que** le rotor (42) est agencé sur la plaque de manière à minimiser la distance entre le bord périphérique extérieur du rotor (42) et le bord périphérique extérieur (72) de la plaque (30) correspondant à la zone d'engrènement (70), et **en ce que** le diamètre du pignon (62) est supérieur à celui du rotor (42) de manière à être en porte-à-faux par rapport à la plaque (30) dans la zone d'engrènement (70).

2. Module d'entraînement (13) selon la revendication précédente, **caractérisé en ce que** l'actionneur (38, 40) comporte un stylet (44, 46) mobile suivant une direction parallèle au plan de la plaque (30), le stylet (44, 46) étant muni à son extrémité libre d'un cliquet (48, 50) prévu pour coopérer avec une denture (52) à dents de scie aménagée sur le bord périphérique extérieur du rotor (42) en vue de l'entraîner en rotation séquentiellement, et **en ce que** la position angulaire de la zone d`encliquetage du cliquet (48, 50) avec le rotor (42) est légèrement décalée angulairement par rapport à la zone d'engrènement (70).

3. Module d'entraînement (13) selon la revendication précédente, **caractérisé en ce que** le stylet (44, 46) s'étend suivant une direction qui coupe l'actionneur (38, 40) en deux parties globalement symétriques.

4. Module d'entraînement (13) selon la revendication 2 ou 3, **caractérisé en ce qu'**il est prévu deux actionneurs (38, 40) qui comportent chacun un stylet (44, 46) mobile dont l'extrémité libre est pourvue d'un cliquet (48, 50), l'un de poussée, l'autre de traction, coopérant avec la denture (52) du rotor (42) de part et d'autre de la zone d'engrènement (70).

5. Module d'entraînement (13) selon la revendication précédente, **caractérisé en ce que** les actionneurs (38, 40) décrivent entre eux un angle compris globalement entre quatre-vingt degrés et cent quarante degrés, la bissectrice de cet angle passant par la zone d'engrènement (70) et par l'axe de rotation du rotor (42), de sorte que la plaque (30) a une forme générale en "V" définie par le contour extérieur de la plaque (30).

6. Module d'entraînement (13) selon la revendication précédente, **caractérisé en ce que** la plaque (30) comporte une portion centrale (100) qui porte le rotor (42) et deux portions latérales (102, 104), **en ce que** le contour de la plaque (30) correspond globalement à l'intersection de deux rectangles, qui sont orthogonaux entre eux et qui forment les deux portions latérales (102, 104), avec un rectangle transversal, qui forme la portion centrale (100), le rectangle transversal décrivant un angle de quarante-cinq degrés par rapport à chacun des deux autres rectangles, **en ce que** la majeure partie de la surface de chaque portion latérale (102, 104) est occupée par un actionneur (38, 40) alors que la majeure partie de la surface de la portion centrale (100) est occupée par le rotor (42), et **en ce que** la zone d'engrènement (70) est agencée à proximité d'un des bords périphériques (72) de la portion centrale (100).

7. Module d'entraînement (13) selon la revendication précédente, **caractérisé en ce que** la plaque (30) comporte des plages de connexion (56, 57, 58, 59) pour le raccordement des actionneurs (38, 40) à un module électronique, et **en ce que** les plages (56, 57, 58, 59) sont agencées sur la portion centrale (100), du côté opposé à la zone d'engrènement (70) par rapport à l'axe du rotor (42).

8. Module d'entraînement (13) selon l'une quelconque des revendications précédentes, **caractérisé en ce qu'**il est agencé à l'intérieur d'un boîtier (12) comportant une platine inférieure (106) prévue pour être fixée sur un élément de pièce d'horlogerie (10) tel qu'une platine (26) de mouvement et un capot (108) fixé sur la platine inférieure (106).

9. Module d'entraînement (13) selon la revendication précédente, **caractérisé en ce que** le capot (108) comporte une échancrure (112) ouverte dans un de ses bords périphériques extérieurs et **en ce que** le pignon (62) est logé dans l'échancrure (112).

10. Pièce d'horlogerie (10) comportant un rouage (22) entraîné en rotation par le module d'entraînement (13) selon l'une quelconque des revendications 1 à 9.

## Claims

1. Drive module (13) intended to engage with a clock wheel (28) having a plate (30) made of crystalline or amorphous material comprising a lower layer, which forms a substrate (32), and an upper layer (34), into which a MEMS type micromotor (36) is etched, wherein the micromotor (36) has at least one actuator (38, 40) rotatably driving a rotor (42), a pinion (62) arranged coaxially to the rotor being rotatably connected to said rotor and being arranged above said rotor, **characterised in that** said pinion is provided to engage with the clock wheel in an engagement zone (70) located close to an outer peripheral edge (72) of the plate (30), that the rotor (42) is disposed on the plate in order to minimise the distance between the outer peripheral edge of the rotor (42) and the outer peripheral edge (72) of the plate (30) corresponding to the engagement zone (70), and that the diameter of the pinion (62) is larger than that of the rotor (42) so as to overhang relative to the plate (30) in the engagement zone (70).

2. Drive module (13) according claim 1, **characterised in that** the actuator (38, 40) has a stylus (44, 46), which is movable in a parallel direction to the plane of the plate (30), which stylus (44, 46) is fitted on its free end with a pawl (48, 50) provided to cooperate with a saw tooth gearing (52) disposed on the outer peripheral edge of the rotor (42) in order to rotatably drive it sequentially, and that the angular position of the interlocking zone of the pawl (48, 50) with the rotor (42) is shifted slightly at an angle in relation to the engagement zone (70).

3. Drive module (13) according to claim 2, **characterised in that** the stylus (44, 46) extends in a direction that separates the actuator (38, 40) into two fully symmetrical parts.

4. Drive module (13) according to claim 2 or 3, **characterised in that** two actuators (38, 40) are provided, each having a movable stylus (44, 46), the free end of which is provided with a pawl (48, 50), one for pushing, the other for pulling, to cooperate with the gearing (52) of the rotor (42) on either side of the engagement zone (70).

5. Drive module (13) according to claim 4, **characterised in that** between them the actuators (38, 40) describe an angle in the overall range of between eighty degrees and a hundred and forty degrees, wherein the bisector of this angle passes through the engagement zone (70) and through the axis of rotation of the rotor (42), so that the plate (30) has a "V" shape in general defined by the outer contour of the plate (30).

6. Drive module (13) according to claim 5, **characterised in that** the plate (30) has a central portion (100), which supports the rotor (42) and two lateral portions (102, 104), that the contour of the plate (30) corresponds overall with the intersection of two rectangles, which are orthogonal to one another and form the two lateral portions (102, 104), with a transverse rectangle forming the central portion (100), said transverse rectangle describing an angle of forty five degrees in relation to each of the two other rectangles, that the major part of the surface of each lateral portion (102, 104) is occupied by an actuator (38, 40), whereas the major part of the surface of the central portion (100) is occupied by the rotor (42), and that the engagement zone (70) is disposed close to one of the peripheral edges (72) of the central portion (100).

7. Drive module (13) according to claim 6, **characterised in that** the plate (30) has terminals (56, 57, 58, 59) for connection of the actuators (38, 40) to an electronic module, and that the terminals (56, 57, 58, 59) are disposed on the central portion (100) on the opposite side to the engagement zone (70) in relation to the axis of the rotor (42).

8. Drive module (13) according to any one of the preceding claims, **characterised in that** it is disposed inside a case (12) having a lower plate (108) provided to be fastened to a timepiece element (10) such as a movement plate (26) and a cover (108) fastened to the lower plate (106).

9. Drive module (13) according to claim 8, **characterised in that** the cover (108) has an open indentation (112) in one of its outer peripheral edges, and that the pinion (62) is housed in the indentation (112).

10. Timepiece (10) having a movement (22) rotatably driven by the drive module (13) according to any one of claims 1 to 9,

## Patentansprüche

1. Antriebsmodul (13), das dazu bestimmt ist, mit einem Uhrenrad (28) zu kämmen, enthaltend eine Platte (30) aus kristallinem bzw. amorphem Material mit einer unteren Schicht, die ein Substrat (32) bildet, und mit einer oberen Schicht (34), in welcher ein Mikromotor (36) vom Typ MEMS geätzt ist, wobei der Mikromotor (36) zumindest ein Betätigungsglied (38, 40) aufweist, das einen Rotor (42) drehend antreibt, wobei ein koaxial zum Rotor verlaufendes Ritzel (62) drehfest mit dem Rotor verbunden und oberhalb des Rotors angeordnet ist, **dadurch gekennzeichnet, dass** das Ritzel dazu vorgesehen ist, mit dem Uhrenrad in einem Kämmbereich (70) zu kämmen, der nahe einem äußeren Umfangsrand (72) der Platte (30) liegt, dass der Rotor (42) so an der Platte angeordnet ist, dass der Abstand zwischen äußerem Umfangsrand des Rotors (42) und äußerem Umfangsrand (72) der Platte (30), der dem Kämmbereich (70) entspricht, minimiert wird, und dass der Durchmesser des Ritzels (62) größer als der des Rotors (42) ist, so dass es in dem Kämmbereich (70) bezüglich der Platte (30) übersteht.

2. Antriebsmodul (13) nach dem vorangehenden Anspruch, **dadurch gekennzeichnet, dass** das Betätigungsglied (38, 40) einen Stift (44, 46) enthält, der in einer Richtung parallel zur Ebene der Platte (30) beweglich ist, wobei der Stift (44, 46) an seinem freien Ende mit einer Sperrklinke (48, 50) versehen ist, die dazu vorgesehen ist, mit einer am äußeren Umfangsrand des Rotors (42) ausgebildeten Sägezahnverzahnung (52) zusammenzuwirken, um diesen sequentiell drehend anzutreiben, und dass die Winkelstellung des Einrastbereichs der Sperrklinke (48, 50) mit dem Rotor (42) im Winkel geringfügig versetzt zum Kämmbereich (70) liegt.

3. Antriebsmodul (13) nach dem vorangehenden Anspruch, **dadurch gekennzeichnet, dass** der Stift (44, 46) sich in einer Richtung erstreckt, die das Betätigungsglied (38, 40) in zwei insgesamt symmetrische Teile unterteilt.

4. Antriebsmodul (13) nach Anspruch 2 oder 3, **dadurch gekennzeichnet, dass** zwei Betätigungsglieder (38, 40) vorgesehen sind, die jeweils einen beweglichen Stift (44, 46) tragen, dessen freies Ende mit einer Sperrklinke (48, 50) versehen ist, zum einen eine Schubklinge, zum anderen eine Zugklinke, die mit der Verzahnung (52) des Rotors (42) beiderseits des Kämmbereichs (70) zusammenwirken.

5. Antriebsmodul (13) nach dem vorangehenden Anspruch, **dadurch gekennzeichnet, dass** die Betätigungsglieder (38, 40) einen Winkel einschließen, der insgesamt zwischen 80° und 140° beträgt, wobei die Winkelhalbierende dieses Winkels durch den Kämmbereich (70) und durch die Drehachse des Rotors (42) verläuft, so dass die Platte (30) eine "V"-Form aufweist, die von der Außenkontur der Platte (30) definiert wird.

6. Antriebsmodul (13) nach dem vorangehenden Anspruch, **dadurch gekennzeichnet, dass** die Platte (30) einen den Rotor (42) tragenden Mittelabschnitt (100) und zwei Seitenabschnitte (102, 104) enthält, dass die Kontur der Platte (30) insgesamt dem Schnittpunkt zweier Rechtecke, die orthogonal zueinander verlaufen und die beiden Seitenabschnitte (102, 104) bilden, mit einem quer verlaufenden Rechteck entspricht, das den Mittelabschnitt (100) bildet, wobei das quer verlaufende Rechteck einen Winkel von 45° bezüglich eines jeden der beiden weiteren Rechtecke beschreibt, dass der Großteil der Fläche eines jeden Seitenabschnitts (102, 104) von einem Betätigungsglied (38, 40) eingenommen wird, während der Großteil der Fläche des Mittelabschnitts (100) von dem Rotor (42) eingenommen wird, und dass der Kämmbereich (70) in der Nähe eines der Umfangsränder (72) des Mittelabschnitts (100) angeordnet ist.

7. Antriebsmodul (13) nach dem vorangehenden Anspruch, **dadurch gekennzeichnet, dass** die Platte (30) Verbindungsbereiche (56, 57, 58, 59) zum Anschluss der Betätigungsglieder (38, 40) an ein elektronisches Modul enthält und dass die Bereiche (56, 57, 58, 59) an dem Mittelabschnitt (100) auf der bezüglich der Achse des Rotors (42) dem Kämmbereich (70) entgegengesetzten Seite angeordnet sind.

8. Antriebsmodul (13) nach einem der vorangehenden Ansprüche, **dadurch gekennzeichnet, dass** es innerhalb eines Gehäuses (12) angeordnet ist, das eine untere Platine (106) enthält, die dazu vorgesehen ist, an einem Uhrenteil (10) befestigt zu werden, wie etwa an einer Uhruverksplatine (26), sowie eine Abdeckung (108), die an der unteren Platine (106) befestigt ist.

9. Antriebsmodul (13) nach dem vorangehenden Anspruch, **dadurch gekennzeichnet, dass** die Abdeckung (108) eine Aussparung (112) aufweist, die in einem ihrer äußeren Umfangsränder eingebracht ist, und dass das Ritzel (62) in der Aussparung (112) aufgenommen ist.

10. Uhr (10) mit einem Räderwerk (22), das von dem Antriebsmodul (13) nach einem der Ansprüche 1 bis 9 drehend angetrieben wird.
